# EUROPEAN PATENT APPLICATION

(11) **EP 1 478 017 A1**
(43) Date of publication of application: **17.11.2004**
(21) Application number: 03734831.5
(22) Date of filing: 22.01.2003
(51) Int. Cl.: H01L 23/08

(54) **METHOD FOR PREPARING GAS-TIGHT TERMINAL**

(30) Priority: 31.01.2002 JP 2002024613
(71) Applicant: Nec Schott Components Corporation, Koka-gun, Shiga 528-0034 (JP)
(72) Inventor: FUKUSHIMA, Daisuke, c/o NEC SCHOTT COMPONENTS CORP, Koka-gun, Shiga 528-0034 (JP); YAMAMOTO, Hidefumi, c/o NEC SCHOTT COMPONENTS CORP, Koka-gun, Shiga 528-0034 (JP)
(74) Representative: Calderbank, Thomas Roger
(86) International application number: PCT/JP2003/000570
(87) International publication number: WO 2003/065445

(57) **Abstract**

An object of the present invention is to provide a low-priced and highly reliable high-vacuum hermetic seal package (30). To this end, a method of manufacturing a hermetic seal package (30) according to the present invention is a method of manufacturing a hermetic seal package (30) by anodically bonding an opening of a cylindrical body (31) for forming an outer frame and the outer edge of a flat glass plate (32) to each other, characterized in that anodically bonded surfaces are 0.04 mm to 200 mm in width and not more than 0.20 µm in surface roughness, the cylindrical body (31) consists of a metal consisting of at least one of Fe, Ni and Co or an alloy or conductive ceramics mainly composed of this metal, the glass plate (32) contains alkaline metal ions, and the quantity of inert gas permeation on bonded portions is 1.0 × 10⁻¹⁵ Pa·m³/s to 1.0 × 10⁻⁸ Pa·m³/s after anodic bonding.

## Description

### Technical Field

The present invention relates to a method of manufacturing a hermetic seal package by bonding a conductive material such as a metal or conductive ceramics and glass to each other. The present invention also relates to a hermetic seal package provided with bonded portions having a small bond width, excellent precision and a small thickness.

### Background Technique

In general, a glass bonding method of heating glass to a high or low temperature for bonding the same to a metal or the like or a bonding method of performing sealing with an adhesive is employed as a method of bonding glass and a conductive material such as a metal or conductive ceramics to each other. The former includes a method referred to as anodic bonding or voltage bonding. The anodic bonding is introduced in Japanese Patent Publication No. 53-28747 and "Interfacial Phenomena in Anodic Bonding of Glass to Kovar Alloy" by Morsy Amin Morsy, Keito Ishizaki, Kenji Ikeuchi and Masao Ushio (Japan Welding Society, Vol. 16, No. 2, 1998). The anodic bonding is a method of feeding a current in a state bringing glass and a conductive material into close contact with each other and expelling alkaline metal ions of Na₂O₃ or the like composing the glass and forming a network structure oppositely to the interface between the glass and the conductive material, which are closely in contact with each other, for strongly bonding the interfacial surfaces of the glass and the conductive material to each other by chemical bonding.

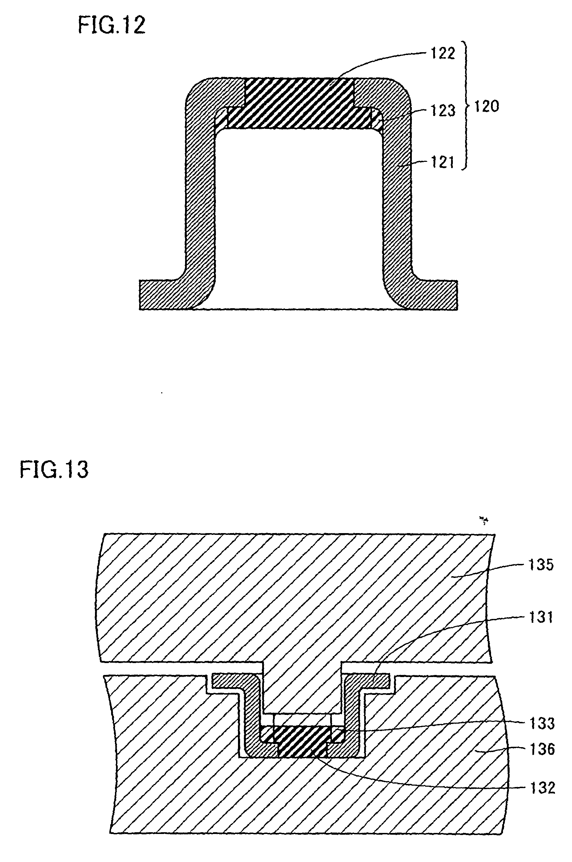

The latter bonding method of performing sealing with an adhesive, referred to as brazing, can attain reliable bonding and is excellent in hermetic sealing property. In order to bond a transparent glass plate to the bottom surface of a metal cylindrical body of a hermetic seal package for a laser diode, for example, a method of heating/melting the elements with glass employed as an adhesive is carried out in general. Fig. 12 shows the structure of a metal cylindrical hermetic seal package 120 for a laser diode. The hermetic seal package 120 is constituted of a metal cylindrical body 121, a glass plate 122 and a glass ring 123. The metal cylindrical body 121, prepared by press molding, has a flange on the cylindrical lower portion. The glass plate 122 is a plate prepared by cutting a borosilicate transparent glass plate into the form of a disc by machining. The glass ring 123 is prepared by press-molding low melting point powdered glass.

In order to manufacture the hermetic seal package, acid cleaning is first performed before assembling, for removing stains of grease or the like from the surface of the metal cylindrical body. After this treatment, a metal cylindrical body 131, a glass plate 132 and a glass ring 133 are inserted into a carbon jig referred to as a sealing jig, as shown in Fig. 13. The sealing jig is constituted of a lower sealing jig 136 and an upper sealing jig 135. The lower sealing jig 136 positions the components while the components are assembled and introduced into a heating oven. The upper sealing jig 135 runs glass so that the metal cylindrical body 131 and the glass plate 132 are bonded to each other through the glass ring 133 and can reliably keep airtightness.

As shown in Fig. 13, the assembly process is so easy that the metal cylindrical body 131 is inserted into the lower sealing jig 136 and the glass ring 133 having a low melting point and the glass plate 132 consisting of borosilicate are inserted into the bottom portion of the metal cylindrical body 131. After this insertion, the upper sealing jig 135 is placed and the sealing jig is introduced into a low-temperature oven for softening the glass ring 133 having a low melting point and bonding the metal cylindrical body 131 and the glass plate 132 to each other. After this bonding, electroless nickel plating is performed on the metal cylindrical body 131, for obtaining the hermetic seal package for a laser diode.

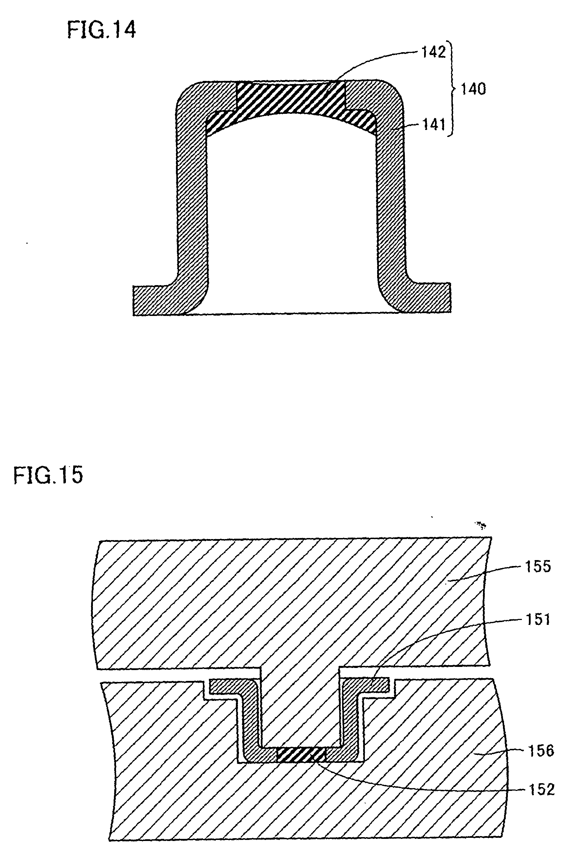

Fig. 14 shows an exemplary hermetic seal package 140 for a laser diode. The hermetic seal package 140 shown in Fig. 14 is an exemplary hermetic seal package for a laser diode, which may have relatively low laser beam transmissivity. The hermetic seal package 140 is constituted of a metal cylindrical body 141 and a glass plate 142. The metal cylindrical body 141, prepared by press molding, has a flange on the cylindrical lower portion. The glass plate 141 is prepared by press-molding borosilicate powdered glass into the form of a disc.

In order to manufacture the hermetic seal package, acid cleaning is performed before assembling, for removing stains of grease or the like from the surface of the metal cylindrical body. After this treatment, a metal cylindrical body 151 and a glass plate 152 are inserted into a carbon jig referred to as a sealing jig, as shown in Fig. 15. The sealing jig is constituted of a lower sealing jig 156 and an upper sealing jig 155. The lower sealing jig 156 positions the components while the components are assembled and introduced into a heating oven. The upper sealing jig 155 runs glass so that the metal cylindrical body 151 and the glass plate 152 are bonded to each other and can reliably keep airtightness.

As shown in Fig. 15, the assembly process is so easy that the metal cylindrical body 151 is inserted into the lower sealing jig 156 and the glass plate 152 consisting of borosilicate is inserted into the bottom portion of the metal cylindrical body 151. After this insertion, the upper sealing jig 155 is placed and the sealing jig is introduced into a high-temperature oven for softening the glass plate 152 of borosilicate and bonding the metal cylindrical body 151 and the glass plate 152 of borosilicate to each other. After this bonding, electroless nickel plating is performed on the metal cylindrical body 151 for performing electro-gold plating thereon, thereby obtaining the hermetic seal package for a laser diode.

In the aforementioned prior art, however, the glass must be heated beyond the softening point for glass bonding, and the temperature may be so excessively high that the elements sealed by bonding are broken. Further, the thickness of the bonded glass is finite and hence the overall height of the package is increased. In addition, the conventional anodic bonding is insufficient in airtightness, and is not yet established as a bonding technique. In the case of using an adhesive, on the other hand, gas is generated when the adhesive is hardened, and aged deterioration easily takes place. Further, equipment for brazing is necessary and the cost for the adhesive is high. In addition, the height of the bonded portions must be increased due to the employment of the adhesive.

### Disclosure of the Invention

An object of the present invention is to provide a low-priced and highly reliable high-vacuum hermetic seal package.

Another object of the present invention is to provide a method of manufacturing a hermetic seal package generating no gas in bonding and having bonded portions bondable without melting. Still another object of the present invention is to provide a method of manufacturing a hermetic seal package provided with bonded portions having a small thickness and high positional accuracy with respect to a bond width.

In order to attain these objects, the inventive method of manufacturing a hermetic seal package is a method of manufacturing a hermetic seal package by anodically bonding an opening of a cylindrical body for forming an outer frame and the outer edge of a flat glass plate to each other, and is characterized in that
anodically bonded surfaces are 0.04 mm to 200 mm in width and not more than 0.20 µm in surface roughness,
the cylindrical body consists of a metal consisting of at least one of Fe, Ni and Co or an alloy or conductive ceramics mainly composed of this metal,
the glass plate contains alkaline metal ions, and
the quantity of inert gas permeation on bonded portions is 1.0 × 10⁻¹⁵ Pa·m³/s to 1.0 × 10⁻⁸ Pa·m³/s after anodic bonding.

The inventive hermetic seal package is a hermetic seal package manufactured by the aforementioned method, and is characterized in that the outer edge of the glass plate is molded in conformity to the shape of the opening of the cylindrical body so that the glass plate fits with the opening of the cylindrical body. The inventive hermetic seal package is another hermetic seal package manufactured by the aforementioned method, and is characterized in that the cylindrical body consists of conductive ceramics containing at least either Mo or W. Further, the inventive hermetic seal package is still another hermetic seal package manufactured by the aforementioned method, and is characterized in that the same is a hermetic seal package container constituting a quartz oscillator or a quartz oscillator carrying a piezoelectric element or a quartz member in the cylindrical body.

### Brief Description of the Drawings

Fig. 1 is a diagram showing the relation between the surface roughness and the quantity of He permeation (Example 1).
Fig. 2 is a diagram showing the relation between the bond width and the quantity of He permeation (Example 1).
Fig. 3 is a sectional view showing the structure of a hermetic seal package for a laser diode according to the present invention (Example 2).
Fig. 4 is a sectional view showing an anodic bonding apparatus for manufacturing the hermetic seal package for a laser diode according to the present invention (Example 2).
Fig. 5 is a conceptual diagram showing a method of measuring the quantity of He permeation.
Fig. 6A is a plan view showing the structure of a surface-mounted quartz oscillator (hermetic seal package) according to the present invention, and Fig. 6B is a sectional view thereof (Example 3).
Fig. 7 is a sectional view showing an anodic bonding apparatus for manufacturing the surface-mounted quartz oscillator (hermetic seal package) according to the present invention (Example 3).
Fig. 8 is a sectional view showing the structure of another hermetic seal package for a laser diode according to the present invention (Example 4).
Fig. 9A is a plan view showing the structure of another surface-mounted quartz oscillator (hermetic seal package) according to the present invention, and Fig. 9B is a sectional view thereof (Example 5).
Fig. 10 is a sectional view showing an anodic bonding apparatus for manufacturing the surface-mounted quartz oscillator (hermetic seal package) according to the present invention (Example 5).
Fig. 11 is a conceptual diagram showing another method of measuring the quantity of He permeation.
Fig. 12 is a sectional view showing the structure of a conventional hermetic seal package for a laser diode.
Fig. 13 is a sectional view showing the structure of a sealing jig for manufacturing the conventional hermetic seal package for a laser diode.
Fig. 14 is a sectional view showing the structure of another conventional hermetic seal package for a laser diode.
Fig. 15 is a sectional view showing the structure of another sealing jig for manufacturing the conventional hermetic seal package for a laser diode.

### Best Modes for Carrying Out the Invention

### (Method of Manufacturing Hermetic Seal Package)

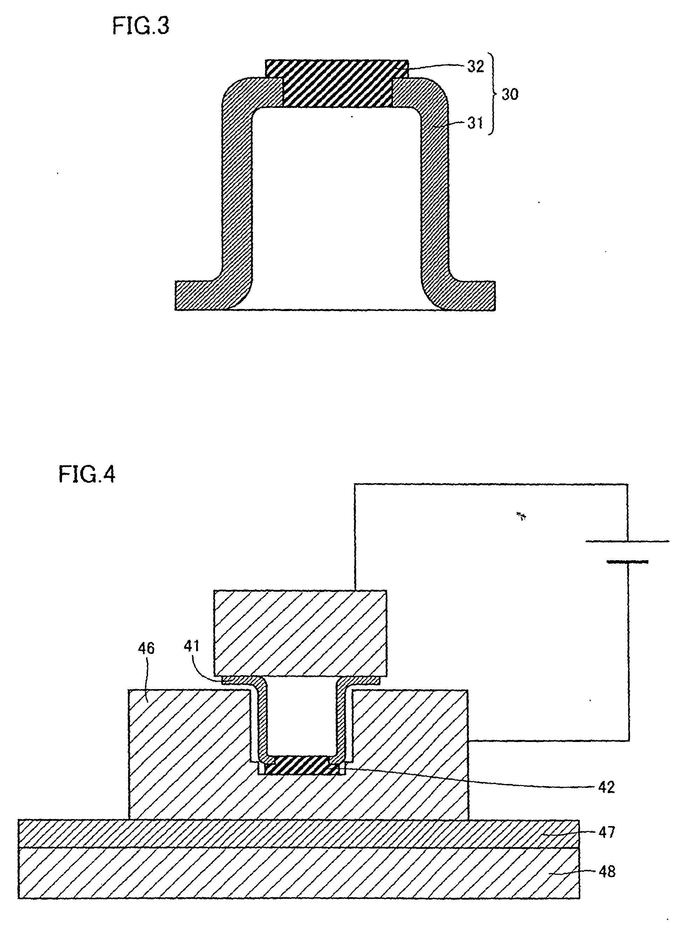

As shown in Fig. 3, the inventive method of manufacturing a hermetic seal package 30 is characterized in a point of anodically bonding an opening of a cylindrical body 31 for forming an outer frame and the outer edge of a flat glass plate 32 to each other. A terminal having a high hermetic sealing property can be manufactured by controlling the bond width of a conductive material and surface roughness of bonded surfaces. According to the present invention, bonding is enabled by simply applying a voltage at a temperature not more than the softening point of bonded glass due to the employment of anodic bonding. Thus, there is no apprehension that sealed elements are broken by a high temperature, and hermetic sealing necessary for a precision quartz oscillator or oscillator is also possible. A conductive material and glass are directly bonded to each other without employing bonding glass and an adhesive, and hence it is possible to reduce the thickness of the bonded portions and lower the overall height of the package. Further, no high-priced adhesive is necessary, and problems of gas discharged in hardening and aged deterioration are also solved. In addition, the number of assembled components can be reduced, and it is possible to easily reduce the manufacturing time, improve the yield, reduce the equipment cost and prevent environmental pollution.

The anodically bonded surfaces must be at least 0.04 mm in width, preferably at least 0.08 mm, in order to improve the hermetic sealing property. While the hermetic sealing property is improved as the width of the anodically bonded surfaces is increased, the width of the anodically bonded surfaces can be suppressed to not more than about 200 mm considering that the hermetic seal package is frequently used as a fine component and in consideration of easiness of anodic bonding. On the other hand, surface roughness (arithmetic mean roughness Ra) of the anodically bonded portions must be set to not more than 0.20 µm, preferably not more than 0.15 µm, in order to improve the hermetic sealing property.

The cylindrical body for forming the outer frame of the hermetic seal package has an opening to be anodically bonded, and the material for the cylindrical body is a metal consisting of at least one of Fe, Ni and Co or an alloy or conductive ceramics mainly composed of this metal in consideration of excellent bondability. The wording "mainly composed of an object" indicates that the subject contains the object by at least 80 %. Conductive ceramics containing at least either Mo or W can be used for the cylindrical body. The outer shape of the opening (section) of the cylindrical body can be circular or quadrangular, and a polygonal outer shape such as an elliptic, triangular or pentagonal shape is also included in the present invention. On the other hand, the depth of the cylindrical body can be adjusted in response to the application. The depth of the cylindrical body can be increased in the case of a hermetic seal package for a laser diode, for example, while the depth of the cylindrical body can be reduced in the case of a surface-mounted quartz oscillator, for example.

The flat glass plate is anodically bonded to the opening of the cylindrical body. The anodically bonded portion is the outer edge of the glass plate. The material for the glass plate is borosilicate glass or phosphate glass, and glass having any composition containing charge-transferable alkaline metal ions therein can be used. Glass containing at least 10 % of an alkaline metal component is preferable in consideration of readiness of anodic bonding. Further, it is possible to use the glass plate 32 having the outer edge molded in conformity to the shape of the opening of the cylindrical body 31 so that the glass plate 32 fits with the opening of the cylindrical body 31 as shown in Fig. 3, for example. In the example shown in Fig. 3, the outer edge of the glass plate 32 is cut in the form of a flange to have irregularity, so that the glass plate 32 fits with the opening of the cylindrical body 31. The overall height of the package can be reduced by bonding this glass plate. Further, the glass plate can be so correctly bonded to the cylindrical body that a terminal having a high hermetic sealing property can be manufactured.

The quantity of inert gas permeation on the bonded portions after anodic bonding must be set to not more than 1.0 × 10⁻⁸ Pa·m³/s, and is preferably not more than 1.0 × 10⁻¹¹ Pa·m³/s, in order to improve the hermetic sealing property not to exert bad influence on operations of the elements stored in the hermetic seal package. While the hermetic sealing property is increased as the lower limit of the quantity of inert gas permeation is reduced, on the other hand, the lower limit of the quantity of permeation is 1.0 × 10⁻¹⁵ Pa·m³/s due to difficulty in manufacturing or the like. The quantity of inert gas permeation on the bonded portions can be measured with a leak detector or the like. Further, helium (He) or the like can be used as the inert gas. The inventive hermetic seal package can be effectively utilized as a hermetic seal package container constituting a quartz oscillator or a quartz oscillator carrying a piezoelectric element or a quartz member in the cylindrical body due to the high hermetic sealing property.

As to an apparatus and a method for anodic bonding, generally well-known ones can be used. For example, an applied voltage of about 500 V to 1000 V, a bonding temperature of about 300°C to 500°C and a bonding time of about 5 minutes to 60 minutes are preferable. When the width of the outer edge (flange) of the bonded cylindrical body is 0.3 mm and the material therefor is Kovar (R), for example, bonding can be made within 5 minutes while setting the applied voltage and the bonding temperature to 500 V and 320°C respectively.

### (Hermetic Seal Package)

As shown in Fig. 3, the inventive hermetic seal package 30, manufactured by bonding the opening of the cylindrical body 31 for forming the outer frame and the outer edge of the flat glass plate 32 to each other by anodic bonding, is characterized in that the anodically bonded surfaces have a width of 0.04 mm to 200 mm and surface roughness of not more than 0.20 µm, the cylindrical body 31 consists of a metal consisting of at least one of Fe, Ni and Co or an alloy or conductive ceramics mainly composed of this metal, the glass plate 32 contains alkaline metal ions, and the quantity of inert gas permeation on the bonded portions is 1.0 × 10⁻¹⁵ Pa·m³/s to 1.0 × 10⁻⁸ Pa·m³/s after anodic bonding.

The inventive hermetic seal package is a hermetic seal package manufactured by the aforementioned method, and is characterized in that the outer edge of the glass plate is molded in conformity to the shape of the opening of the cylindrical body so that the glass plate fits with the opening of the cylindrical body. Further, the inventive hermetic seal package is a hermetic seal package manufactured by the aforementioned method, and is characterized in that the cylindrical body consists of conductive ceramics containing at least either Mo or W. In addition, the inventive hermetic seal package is a hermetic seal package manufactured by the aforementioned method, and is characterized in that the same is a hermetic seal package container constituting a quartz oscillator or a quartz oscillator carrying a piezoelectric element or a quartz member in the cylindrical body.

### Example 1

In order to confirm the relation between the surface roughness of anodically bonded surfaces and the quantity of permeation of helium gas (He) which is inert gas and the relation between the width of the anodically bonded surfaces and the quantity of He permeation, a bonding experiment was conducted. In this experiment, Kovar (R) and glass for Kovar (R) were used for a cylindrical body and a glass plate respectively, for attempting anodic bonding between an opening of the cylindrical body and the outer edge of the glass plate. Kovar (R), which is a glass sealing line metallic material by Westinghouse Electric Company, was composed of 54 % of Fe, 28 % of Ni and 18 % of Co. Borosilicate glass containing 13 % of Na⁺ was used as the glass for Kovar (R).

For the anodic bonding, an anodic bonding apparatus having a structure shown in Fig. 4 was employed for setting a heater 48 serving as a heat source to reach a temperature of 500°C and placing a nonconductive ceramics plate 47 thereon. A sealing jig 46 prepared from a conductive metallic material such as brass was placed on the ceramics plate 47, in order to prevent a hermetic seal package from displacement in bonding. Then, a glass plate 42 and a cylindrical body 41 were arranged and assembled in the sealing jig 46 to be in the positional relation shown in Fig. 4. Consequently, the opening of the cylindrical body and the outer edge of the glass plate came into contact with each other. Thereafter a DC voltage of 700 V was applied for about 10 minutes for causing atomic transfer between the glass plate and the metal and carrying out the anodic bonding.

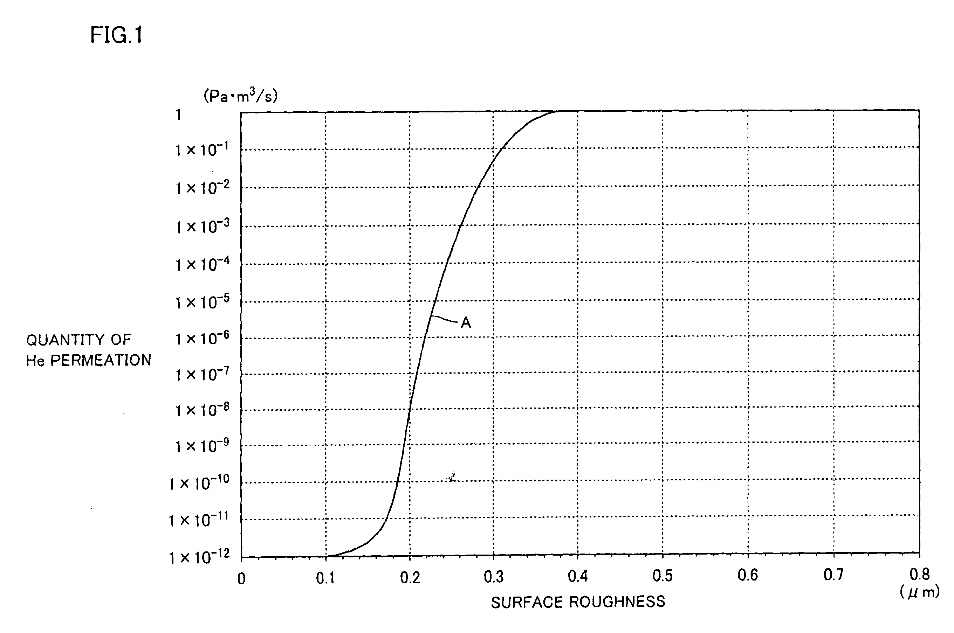

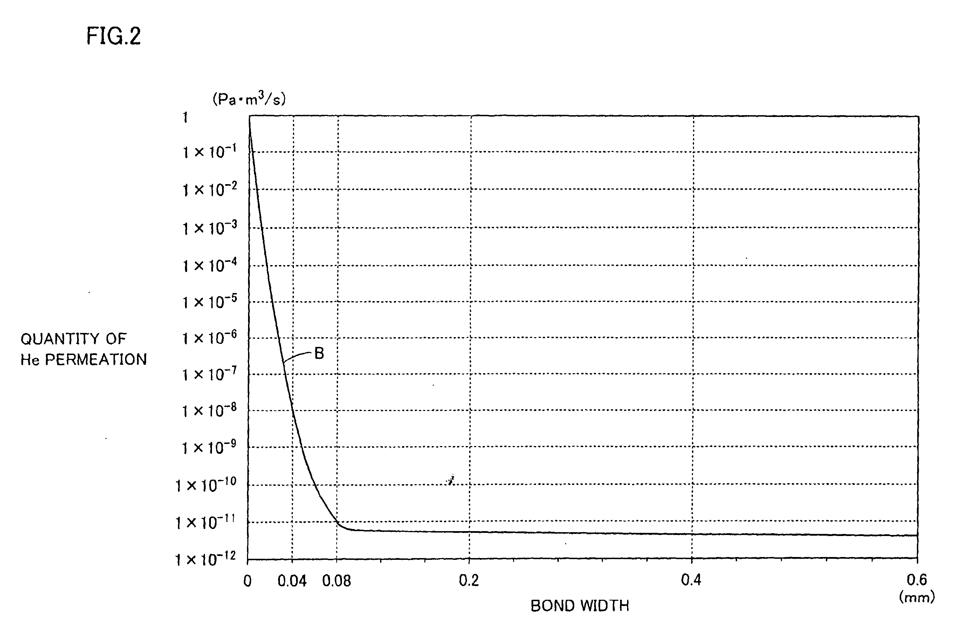

Fig. 1 shows the relation between the surface roughness and the quantity of He permeation. Fig. 2 shows the relation between the width of the bonded surfaces and the quantity of He permeation. In each case, the quantity of He permeation was measured with a helium leak detector after bonding Kovar (R) and glass to each other, for predicting transition of the quantity of permeation from this value. Bonding between Kovar (R) and glass for Fe-Ni 42 was also experimented. Consequently, a ring allowing confirmation of transference of alkaline metal ions in the glass was visually confirmable, while bonding was impossible. This resulted from influence by the difference between the thermal expansion coefficients of Kovar (R) and glass.

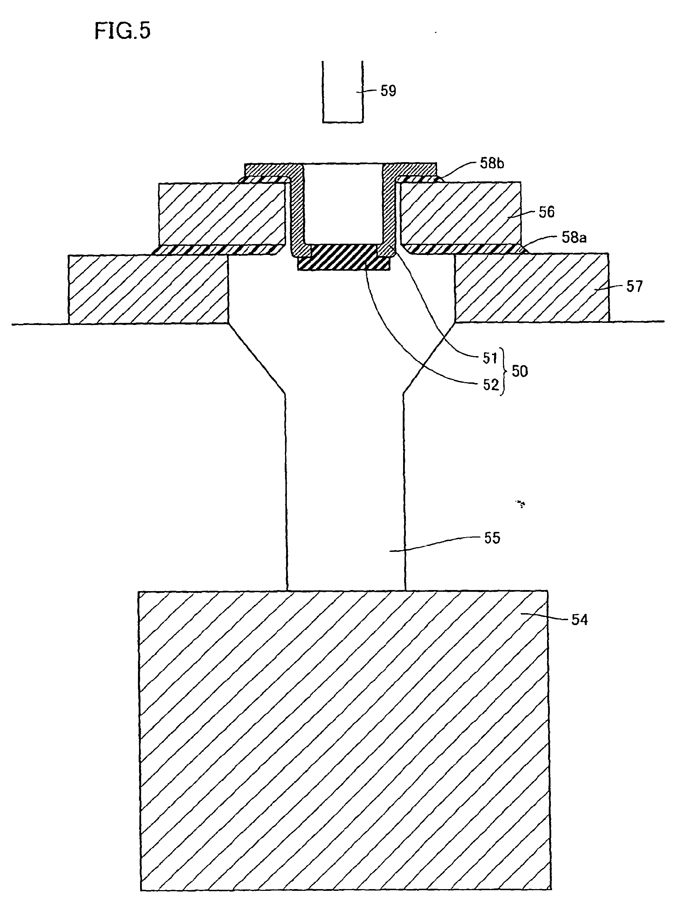

The quantity of He permeation was measured with the helium leak detector (HELIOT 301 by ULVAC. Inc.). As to the measuring method, silicon grease 58a was applied onto a sample stand 57 and a rubber plate 56 was placed thereon, as shown in Fig. 5. Then, another silicon grease 58b was applied thereon, and a cylindrical body 51 constituting a hermetic seal package 50 was set so that a flange thereof was placed on the rubber plate 56. Then, He was discharged from an He discharge nozzle 59, for detecting He leaking from bonded portions of the cylindrical body 51 and a glass plate 52 constituting the hermetic seal package 50 with a helium leak detector 54 through a pipe 55.

A characteristic curve A in Fig. 1 shows the relation between the surface roughness and the quantity of He permeation. As obvious from the characteristic curve A, it was confirmable that the surface roughness of the bonded surfaces must be set to not more than 0.20 µm, preferably not more than 0.15 µm, in order to set the quantity of He permeation to not more than 1.0 × 10⁻⁸ Pa·cm³/s. A characteristic curve B in Fig. 2 shows the relation between the width of the bonded surfaces and the quantity of He permeation. The experiment was conducted as to a sample provided with bonded surfaces having surface roughness of not more than 0.20 µm. As obvious from the characteristic curve B, it was confirmable that the width of the bonded surfaces must be set to at least 0.04 mm, preferably at least 0.08 mm, in order to set the quantity of He permeation to not more than 1.0 × 10⁻⁸ Pa·cm³/s.

### Example 2

A hermetic seal package 30 for a laser diode having the structure shown in Fig. 3 was manufactured. The hermetic seal package 30 is constituted of a metal cylindrical body 31 and a glass plate 32. The metal cylindrical body 31 consisting of an alloy of Fe, Co and Ni is prepared by press molding in a cylindrical form and has a flange on the lower portion thereof As to the glass plate 32, a sample consisting of borosilicate glass, containing Na⁺ and prepared by cutting a portion engaged into the bottom portion of the metal cylindrical body 31 into the form of a disc by machining was used. The glass plate 32 preferably has a thermal expansion coefficient as close as possible to that of the metal cylindrical body 31 in view of bonding. Therefore, borosilicate glass for sealing Kovar (R) having a thermal expansion coefficient of 50 × 10⁻⁷/°C was used since the thermal expansion coefficient of Kovar (R) is about 47 × 10⁻⁷/°C.

As to the sealing process, a bonded surface formed by the opening of the metal cylindrical body 31 was polished to reach a state close to a mirror surface, and the flatness was reduced to the minimum for improving smoothness. This is because the method of anodic bonding bringing surfaces into close contact with each other and causing bonding between surface atoms thereby performing bonding in a solid phase is used. It was confirmable by the bonding experiment that anodic bonding is enabled by setting a DC voltage, the temperature of a heat source for heating the bonded objects and the bonding time to 500 V to 1000 V, 300°C to 500°C and 5 minutes to 10 minutes respectively when the surface roughness (arithmetic mean roughness Ra) is 0.10 µm and the bond width is 1 mm.

In this Example, therefore, the anodic bonding apparatus having the structure shown in Fig. 4 was employed for setting the heater 48 serving as the heat source to reach the temperature of 500°C and placing the nonconductive ceramics plate 47 thereon. The sealing jig 46 prepared from a conductive metallic material such as brass was placed on the ceramics plate 47, in order to prevent the hermetic seal package from displacement in bonding. Then, the glass plate 42 and the cylindrical body 41 were arranged and assembled in the sealing jig 46 to be in the positional relation shown in Fig. 4. Consequently, the opening of the cylindrical body and the outer edge of the glass plate came into contact with each other. Thereafter a DC power source of 700 V was applied for about 10 minutes for causing atomic transfer between the glass plate and the metal and carrying out anodic bonding. Then, electroless nickel plating was performed on the metal cylindrical body 41 with dilute hydrochloric acid hardly influencing an oxide film, for obtaining the hermetic seal package for a laser diode. In order to confirm airtightness on the bonded portions of the metal cylindrical body 41 and the glass plate 42 as to the obtained hermetic seal package, the quantity of He permeation on the bonded portions was measured with a helium leak detector, similarly to Example 1. Consequently, the quantity of He permeation was 5 × 10⁻¹⁰ Pa·m³/s.

### Example 3

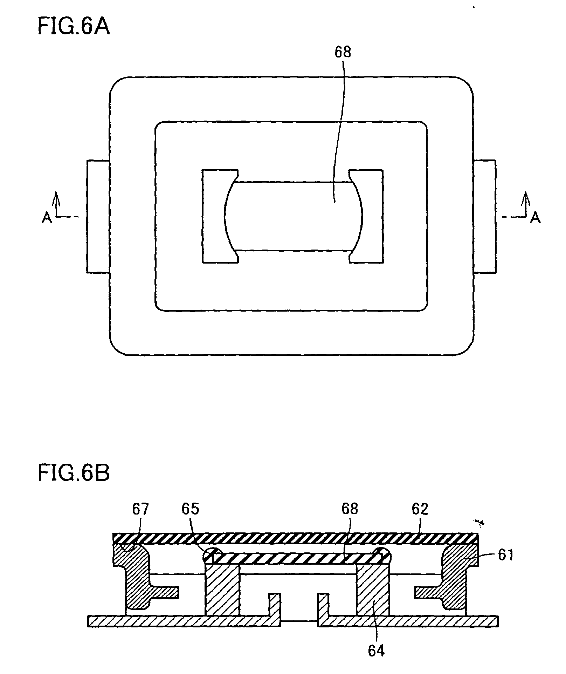

A surface-mounted quartz oscillator having a structure shown in Figs. 6A and 6B was manufactured. Fig. 6A is a plan view, and Fig. 6B is a sectional view taken along the line A-A in Fig. 6A. The quartz oscillator has a structure obtained by sealing a ceramics cylindrical body 61 for forming an outer frame with a flat transparent glass plate 62 consisting of borosilicate. In the cylindrical body 61, a quartz member 68 is bonded to an internal electrode 64 with a brazing filler metal 65. In this Example, a cylindrical body 61 consisting of conductive ceramics mainly composed of Fe, Ni and Co and a borosilicate glass plate 62 containing Na⁺ were used. First, the surface of an opening 67 of the cylindrical body 61 was mirror-ground for setting surface roughness to not more than 0.10 µm. The bond width was set to 1 mm After the mirror grinding, foreign matter such as shavings was completely washed out with an ethanol-based liquid in a cleaning step. The mirror grinding was performed to flatten the overall surface so that warpage (flatness) of the mirror-ground bonded surface was not more than about 2.0 µm. After the cleaning, the quartz member 68 was bonded to the internal electrode 64 with the brazing filler metal 65.

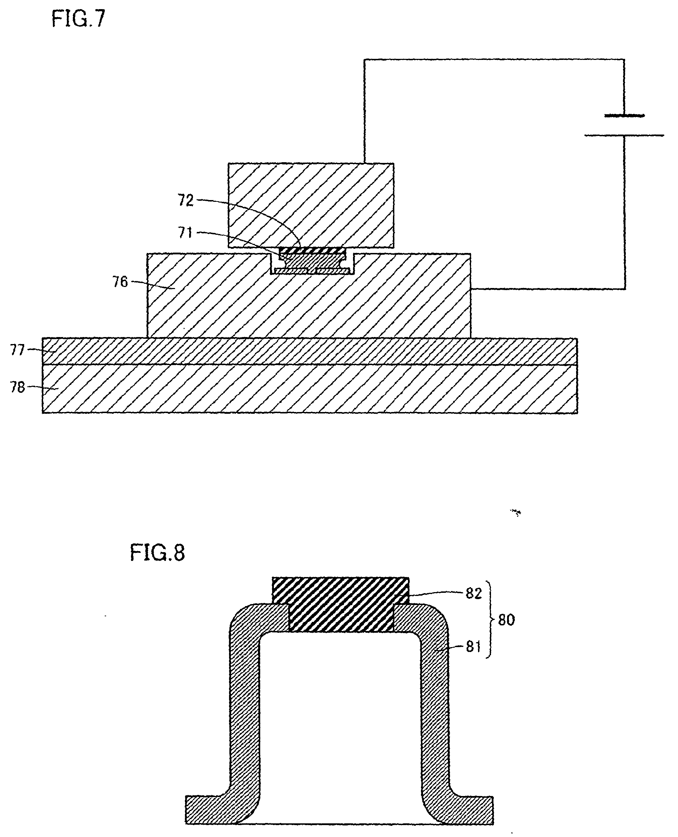

After the bonding, a cylindrical body 71 carrying the quartz member was inserted into a sealing jig 76 in a vacuum oven, as shown in Fig. 7. Then, a transparent flat glass plate 72 consisting of borosilicate was placed on the cylindrical body 71, for bringing an opening of the cylindrical body 71 and the outer edge of the glass plate 72 into contact with each other. Then, setting was made so that voltages of an anode and a cathode were applied to the cylindrical body 71 and the glass plate 72 respectively. At this time, the temperature in the sealing jig 76 was about 320°C, and anodic bonding was performed by applying a DC voltage of 500 V for about 5 minutes, for obtaining a hermetic seal package forming the quartz oscillator. The hermetic seal package was manufactured under a vacuum atmosphere with an evacuative oven. Consequently, it was possible to easily perform sealing requiring high precision.

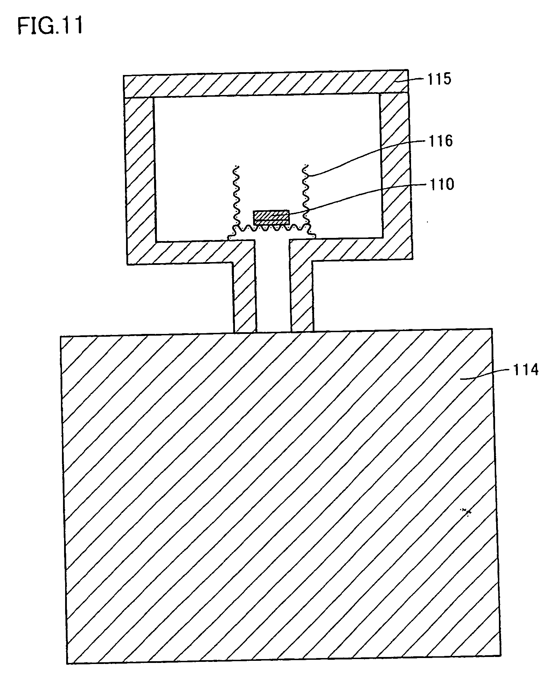

In order to confirm airtightness on the bonded surfaces of the ceramics cylindrical body and the borosilicate glass plate as to the obtained hermetic seal package, the quantity of He permeation on the bonded portions was measured with a helium leak detector. As to the measuring method, the sealed quartz oscillator was introduced into an He vessel having an internal pressure of about 3.0 kg/cm³, and the quartz oscillator was taken out after about 2 hours. Then, a quartz oscillator 110 was introduced into a net 116 in a measuring vessel 115 having a structure shown in Fig. 11, for measuring the quantity of He permeation from the bonded portions of the cylindrical body and the glass plate with the helium detector (HELIOT 301 by ULVAC. Inc.) 114. Consequently, the quantity of He permeation was 1 × 10⁻¹⁰ Pa·m³/s.

### Example 4

A hermetic seal package 80 for a laser diode having a structure shown in Fig. 8 was manufactured. The hermetic seal package 80 is constituted of a metal cylindrical body 81 and a glass plate 82. The cylindrical body 81 for forming an outer frame, consisting of an alloy of Fe and Ni, was prepared by press molding. As to the cylindrical body 81 having a flange on the lower portion thereof, Au was electroplated on an Ni surface formed by electroplating. The glass plate 82, having a shape obtained by cutting a portion engaged into the bottom of the metal cylindrical body 81 into the form of a convex circle by machining, was made of borosilicate glass, and contained Na⁺. It is necessary to use borosilicate glass having a thermal expansion coefficient as close as possible to that of the metal forming the cylindrical body 81. In this Example, the cylindrical body 81 was prepared from Fe-Ni 50 having a thermal expansion coefficient of about 98 × 10⁻⁷/°C, and hence borosilicate glass having a thermal expansion coefficient of about 100 × 10⁻⁷/°C was used.

As to the sealing process, a bonded surface formed by the opening of the metal cylindrical body 81 was polished to reach a state close to a mirror surface, for reducing flatness and increasing smoothness. This is because the method of anodic bonding bringing surfaces into close contact with each other and causing bonding between surface atoms thereby performing bonding in a solid phase is used. In this Example, the surface roughness was 0.10 µm, and the bond width was set to 1 mm. The hermetic seal package was bonded through the bonding apparatus having the structure shown in Fig. 4 for Example 2. The heater 48 serving as the heat source was set to reach a temperature of 300°C, and the nonconductive ceramics plate 47 was placed on the heater 48.

The sealing jig 46 prepared from a conductive metallic material such as brass was placed on the ceramics plate 47, in order to prevent displacement in bonding. Then, the glass plate 42 and the metal cylindrical body 41 were arranged and assembled in the sealing jig 46, as shown in Fig. 4. Consequently, the opening of the cylindrical body and the outer edge of the glass plate came into contact with each other. Thereafter a DC current was applied at 500 V for about 30 minutes for causing atomic transfer between the glass and the metal and carrying out anodic bonding, for obtaining the hermetic seal package for a laser diode. In order to confirm airtightness on the bonded portions of the metal cylindrical body and the glass plate as to the obtained hermetic seal package, the quantity of He permeation on the bonded portions was measured similarly to Example 1. Consequently, the quantity of He permeation was 5 × 10⁻¹⁰ Pa·m³/s.

### Example 5

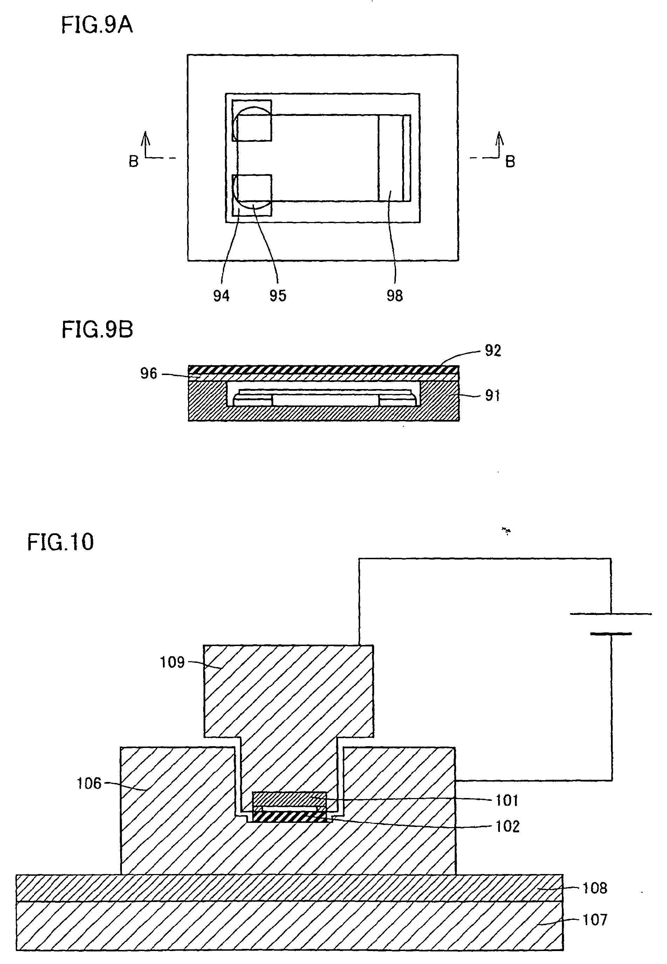

A surface-mounted quartz oscillator having a structure shown in Figs. 9A and 9B was manufactured. Fig. 9A is a plan view, and Fig. 9B is a sectional view taken along the line B-B in Fig. 9A. The quartz oscillator has a structure obtained by sealing a cylindrical body 91 for forming an outer frame with a flat transparent glass plate 92 consisting of borosilicate. In the cylindrical body 91, a quartz member 98 is bonded to an internal electrode 94 with a brazing filler metal 95. In this Example, the cylindrical body 91 consisting of an alloy mainly composed of Fe, Ni and Co and the borosilicate glass plate 92 containing Na⁺ were used. First, a pasted Mo material was printed on the surface of an opening of the cylindrical body 91 before carrying the quartz member 98, for forming an Mo layer 96. After the printing, sintering was performed at about 1400°C, for increasing adhesion strength between the Mo layer 96 and the cylindrical body 91. Then, the surface of the Mo layer 96 was mirror-ground for setting the surface roughness to not more than 0.10 µm while setting the bond width of the bonded surface to 1 mm

After the mirror grinding, cleaning was performed for completely washing out foreign matter such as shavings with an ethanol-based liquid. Further warpage (flatness) of the bonded surface was set to not more than about 2.0 µm by mirror grinding. The Mo layer 96 may be replaced with a W layer, for example, depending on convenience of design or the like. Then, the quartz member 98 was bonded to the internal electrode 94 with the brazing filler metal 95. After the bonding, a glass plate 102 was inserted into a lower sealing jig 106 provided on a heater 108 in an oven of a nitrogen atmosphere, as shown in Fig. 10. Then, a cylindrical body 101 carrying the quartz member 98 was placed on the glass plate 102, and an upper sealing jig 109 was placed thereon. In the sealing jig, the opening of the cylindrical body and the outer edge of the glass plate were brought into contact with each other.

Then, the internal temperature of the sealing jig was set to about 450°C, and setting was made so that the cylindrical body 101 formed an anode and the glass plate 102 formed a cathode. Anodic bonding was performed by applying a DC voltage of 600 V for about 20 minutes, for obtaining a hermetic seal package forming the quartz oscillator. The atmosphere in manufacturing can be replaced with a vacuum atmosphere, and precision sealing can be easily performed in this case. In order to confirm airtightness on the bonded portions of the cylindrical body and the glass plate in the obtained hermetic seal package, the quantity of He permeation was measured similarly to Example 3, to obtain an He permeation value of 1 × 10⁻¹⁰ Pa·m³/s.

The embodiment and Examples disclosed this time must be considered illustrative and not restrictive in all points. The range of the present invention is shown not by the above description but by the scope of claim for patent, and it is intended that all modifications within the meaning and range equivalent to the scope of claim for patent are included.

### Industrial Applicability

According to the present invention, it is possible to manufacture a high-vacuum hermetic seal package having high reliability at a low cost. Further, no gas is generated in bonding so that the bonded portions can be bonded without melting. In addition, it is possible to manufacture a hermetic seal package provided with bonded portions having a small thickness and high positional accuracy with respect to a bond width.

## Claims

1. A method of manufacturing a hermetic seal package (30) by anodically bonding an opening of a cylindrical body (31) for forming an outer frame and the outer edge of a flat glass plate (32) to each other, wherein
anodically bonded surfaces are 0.04 mm to 200 mm in width and not more than 0.20 µm in surface roughness,
said cylindrical body (31) consists of a metal consisting of at least one of Fe, Ni and Co or an alloy or conductive ceramics mainly composed of said metal,
said glass plate (32) contains alkaline metal ions, and
the quantity of inert gas permeation on bonded portions is 1.0 × 10⁻¹⁵ Pa·m³/s to 1.0 × 10⁻⁸ Pa·m³/s after anodic bonding.

2. A hermetic seal package manufactured by the method according to claim 1, wherein the outer edge of the glass plate (32) is molded in conformity to the shape of the opening of the cylindrical body (31) so that the glass plate (32) fits with the opening of the cylindrical body (31).

3. A hermetic seal package manufactured by the method according to claim 1, wherein the cylindrical body (31) consists of conductive ceramics containing at least either Mo or W.

4. A hermetic seal package manufactured by the method according to claim 1, being a hermetic seal package container constituting a quartz oscillator or a quartz oscillator carrying a piezoelectric element or a quartz member in the cylindrical body (31).
